# EUROPÄISCHE PATENTSCHRIFT

(11) **EP 0 592 992 B1**
(45) Veröffentlichungstag und Bekanntmachung des Hinweises auf die Patenterteilung: **03.03.1999**
(21) Anmeldenummer: 93116455.2
(22) Anmeldetag: 11.10.1993
(51) Int. Cl.: H01L 29/08, H01L 29/744

(54) **Abschaltbarer Thyristor**
GTO-thyristor
Thyristor à commande d'extinction

(30) Priorität: 15.10.1992 DE 4234828
(43) Veröffentlichungstag der Anmeldung: 20.04.1994
(73) Patentinhaber: SIEMENS AKTIENGESELLSCHAFT, 80333 München (DE)
(72) Erfinder: Willmeroth, Armin, Dipl.-Phys., D-86163 Augsburg (DE)

(56) Entgegenhaltungen:
- EP-A- 0 364 354
- EP-A- 0 440 924
- PATENT ABSTRACTS OF JAPAN vol. 15, no. 288 (E-1092)22. Juli 1991 & JP-A-03 101 268 (HITACHI LTD) 26. April 1991
- PATENT ABSTRACTS OF JAPAN vol. 11, no. 73 (E-486)(2520) 5. März 1987 & JP-A-61 229 363 (HITACHI LTD) 13. Oktober 1986
- RESEARCH DISCLOSURE Nr. 289 , Mai 1988 , NEW YORK, NY, USA Seiten 338 - 339 'Shorted Anode Emitter Configuration in a GTO Thyristor'
- PATENT ABSTRACTS OF JAPAN vol. 6, no. 60 (E-102)(938) 17. April 1982 & JP-A-57 001 257 (HITACHI SEISAKUSHO K.K) 6. Januar 1982

## Beschreibung

Die Erfindung bezieht sich auf einen GTO-Thyristor mit einem kreisrunden Halbleiterkörper, der katodenseitig eine Vielzahl von streifenförmigen Emitterzonen hat, die in Form zueinander konzentrischer Ringe derart angeordnet sind, daß ihre Längsachsen radial zum Halbleiterkörper liegen, und mit zueinander konzentrischen ringförmigen voneinander beabstandeten Anodenemitterzonen.

Solche GTO-Thyristoren sind z.B. in der europäischen Patentanmeldung 0 440 924 beschrieben worden. Durch die erwähnte Form der Katoden- und Anodenemitterzonen lassen sich tangentiale Justierfehler vermeiden. Bei radialen Justierfehlern kann es aber insbesondere bei sehr feinen Anodenemitter-Strukturen vorkommen, daß eine oder mehrere der ringförmigen Anodenemitterzonen aus dem Stromflußbereich der Katodenemitterzonen einer der Ringe auswandern. Unter Stromflußbereich wird dabei ein Bereich im Halbleiterkörper verstanden, der sich von den katodenseitigen Emitterzonen unter einem Winkel von etwa 45° zur Anodenseite hin verbreitert. Das Auswandern kann dazu führen, daß die Katodenemitterzonen ein- und desselben Rings auf der einen Seite des GTO-Thyristors mehr Strom führen als auf der gegenüberliegenden Seite.

Es ist jedoch erforderlich, daß die Konzentration des Laststroms im Thyristor gegen Ende der Abschaltphase auf wenige der streifenförmigen Katodenemitter vermieden wird. Der Erfindung liegt daher die Aufgabe zugrunde, einen GTO-Thyristor der erwähnten Art so zu verbessern, daß alle katodenseitigen Emitterzonen mindestens des äußeren Rings schon vor Beginn des Abschaltvorgangs gleichmäßig Strom führen.

Diese Aufgabe wird dadurch gelöst, daß zwischen einer ersten Gruppe von Anodenemitterzonen (4), die dem äußersten Katodenemitterring (3) gegenüberliegen und einer zweiten Gruppe von Anodenemitterzonen (4), die den nächsten inneren Katodenemitterring (2) gegenüber liegen, ein Bereich (5) des entgegengesetzten Leitungstyps liegt, der breiter ist als der Abstand (a) zwischen den Anodenemitterzonen innerhalb der ersten oder zweiten Gruppe, und daß der Abstand (c) zwischen der Innenkante der innersten Anodenemitterzone der zweiten Gruppe und der Außenkante der äußersten Anodenemitterzone der zweiten Gruppe höchstens gleich einer Länge ist, die etwa der Länge (1) des inneren Katodenrings (2) zuzüglich der doppelten Dicke des Halbleiterkörpers und abzüglich der Breite (b) des Bereichs (5) des entgegengesetzten Leitungstyps entspricht.

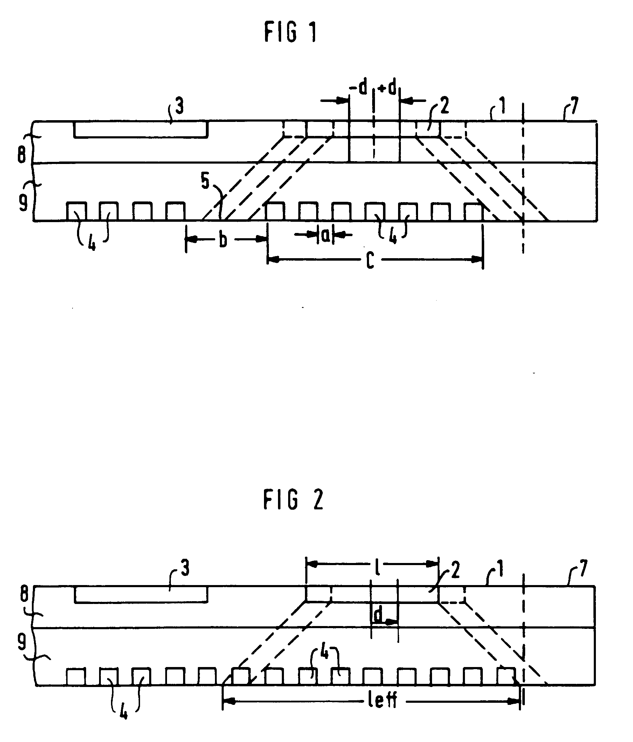

Weiterbildung der Erfindung sind Gegenstand von Unteransprüchen. Die Erfindung wird anhand eines Ausführungsbeispiels in Verbindung mit den Figuren 1 und 2 näher erläutert. Dabei zeigt Figur 1 das Prinzip der Erfindung. Anhand von Figur 2 wird der Stand der Technik erläutert.

Der GTO-Thyristor nach Figur 2 besteht aus einem kreisrunden Halbleiterkörper 1 mit einer katodenseitigen Basiszone 8 und einer zentralen Zone 9. In die katodenseitige Basiszone 8 sind katodenseitige Emitterzonen 2, 3 eingebettet. Die Katodenemitterzonen 2, 3 sind als radiale Streifen ausgebildet und auf einander konzentrischen Ringe auf dem Halbleiterkörper untergebracht, wie z.B. in der eingangs erwähnten EP 0 440 924 A1 beschrieben. Anodenseitig sind in die zentrale Zone 9 ringförmige Anodenemitterzonen 4 eingebettet. Diese Ringe sind zueinander konzentrisch. Auch diese Anordnung ist der erwähnten europäischen Patentanmeldung zu entnehmen. Ein Randbereich 7 des GTO-Thyristors ist aus elektrischen Gründen frei von Anodenemitterzonen.

Es sei angenommen, daß die katodenseitigen Emitterzonen 2 genau auf die anodenseitige Emitterstruktur justiert ist. Dann haben die katodenseitigen Emitterzonen 2 eine Lage, die durch die ausgezogenen Linien gekennzeichnet sind. Der stromführende Bereich der Katodenemitterzonen 2 verbreitert sich zur Anodenseite hin unter einem Winkel von etwa 45°, so daß die katodenseitigen Emitterzonen 2 mit einer Länge 1 mit einer Anzahl von anodenseitigen Emitterringen 4 zusammenarbeiten, durch eine effektive Emitterlänge l_{eff} charakterisiert ist. Dabei ist l_{eff} etwa gleich 1 zuzüglich der doppelten Scheibendicke.

Bei einer nach rechts gerichteten Dejustierung der Anodenemitterzonen 2 um den Betrag d wandert der Stromflußbereich zum Randgebiet 7 aus. Da hier keine Anodenemitterzonen liegen, verringert sich der Strom in der dargestellten Katodenemitterzone und den angrenzenden Katodenemitterzonen.

Gemäß der Erfindung ist nun im GTO-Thyristor nach Figur 1 zwischen denjenigen Anodenemitterringen 4, die den Katodenemitterzonen 2 gegenüberliegen und denjenigen Anodenemitterringen, die den Katodenemitterzonen 3 gegenüberliegen, ein Bereich 5 des den Anodenemitterzonen entgegengesetzten Leitungstyps angeordnet. Der Bereich 5 hat eine Breite b, die größer ist als der Abstand a, den die anodenseitigen Emitterringe 4 voneinander haben. Zweckmaßigerweise hat der Bereich 5 eine Breite b, die der maximalen Dejustierung 2d entspricht. Der Abstand c vom innersten den Katodenemitterzonen 2 gegenüberliegenden Anodenemitterring 4 bis zur Außenkante des äußersten den Katodenemitterzonen 2 gegenüberliegenden Anodenemitterrings ist dabei gleich der effektiven Länge der Katodenemitterzonen 2 abzüglich der Breite b des Bereich 5.

Im genau justierten Zustand der katodenseitigen Emitterzonen 2 (ausgezogene Linien) liegen die den Anodenemitterzonen 2 gegenüberliegenden Anodenemitterringe 4 symmetrisch zur Mitte der Katodenemitterzonen. Bei einer Dejustierung um die Entfernung -d nach links verschiebt sich der Stromflußbereich der Katodenemitterzone nach links, bei einer Dejustierung um den Betrag +d nach rechts verschiebt sich der Stromflußbereich in Richtung zum Rand. Dabei bleiben unabhängig von der Dejustierung innerhalb der Grenzen ±d immer gleich viele Anodenemitterringe 4 im Stromflußbereich der Emitterelektrode 2. D.h., daß der äußere Katodenemitterring unabhängig von der Justierung immer den gleichen Strom führt.

Die beschriebenen Maßnahmen beschränken sich zweckmäßigerweise auf den äußersten Katodenemitterring, da dieser aufgrund der größten Fläche immer den meisten Strom führt. Es ist jedoch auch möglich, z.B. den weiter innen gelegenen Ring mit den Katodenemitterzonen 3 und seinen gegenüberliegenden ringförmigen Anodenzonen gemäß der Erfindung auszubilden.

Da die Dejustierung +d im allgemeinen zwischen 0,1 und 02 mm liegt, beträgt die Breite b des Bereichs 5 zweckmäßigerweise mehr als 0,1 mm. Die Breite b ist auch größer als der Abstand a zwischen den Anodenemitterringen, der z.B. zwischen 0,1 und 0,6 mm betragen kann. Die Breite der Anodenemitterzonen kann z.B. zwischen 0,1 und 0,6 mm liegen.

## Patentansprüche

1. GTO-Thyristor mit einem kreisrunden Halbleiterkörper, der katodenseitig eine Vielzahl von streifenförmigen Emitterzonen hat, die in Form zueinander konzentrischer Ringe derart angeordnet sind, daß ihre Längsachsen radial zum Halbleiterkörper liegen, und mit zueinander konzentrischen ringförmigen voneinander beabstandeten Anodenemitterzonen eines ersten Leitungstyps,
**dadurch gekennzeichnet,** daß zwischen einer ersten Gruppe von Anodenemitterzonen (4), die dem äußersten Katodenemitterring (3) gegenüberliegen und einer zweiten Gruppe von Anodenemitterzonen (4), die den nächsten inneren Katodenemitterring (2) gegenüber liegen, ein Bereich (5) des entgegengesetzten Leitungstyps liegt, der breiter ist als der Abstand (a) zwischen den Anodenemitterzonen innerhalb der ersten oder zweiten Gruppe, und daß der Abstand (c) zwischen der Innenkante der innersten Anodenemitterzone der zweiten Gruppe und der Außenkante der äußersten Anodenemitterzone der zweiten Gruppe höchstens gleich einer Länge ist, die etwa der Länge (1) des inneren Katodenrings (2) zuzüglich der doppelten Dicke des Halbleiterkörpers und abzüglich der Breite (b) des Bereichs (5) des entgegengesetzten Leitungstyps entspricht.

2. GTO-Thyristor nach Anspruch 1,
**dadurch gekennzeichnet,** daß der Bereich (5) breiter als 0,1 mm ist.

3. GTO-Thyristor nach Anspruch 1 oder 2,
**dadurch gekennzeichnet,** daß der Abstand (a) zwischen den Anodenemitterzonen (4) 0,1 bis 0,6 mm beträgt.

4. GTO-Thyristor nach einem der Ansprüche 1 bis 3,
**dadurch gekennzeichnet**, daß die Breite der Anodenemitterzonen 0,1 bis 0,6 mm beträgt.

## Claims

1. GTO thyristor having a circular semiconductor body which has, on the cathode side, a multiplicity of strip-shaped emitter zones which are arranged in the form of mutually concentric rings in such a way that their longitudinal axes lie radially with respect to the semiconductor body, and having mutually concentric, ring-shaped anode emitter zones of a first conduction type which are spaced apart from one another,
characterized in that a region (5) of the opposite conduction type is situated between a first group of anode emitter zones (4) which lie opposite the outermost cathode emitter ring (3) and a second group of anode emitter zones (4) which lie opposite the nearest inner cathode emitter ring (2), which region (5) is wider than the distance (a) between the anode emitter zones within the first or second group, and in that the distance (c) between the inner edge of the innermost anode emitter zone of the second group and the outer edge of the outermost anode emitter zone of the second group it is at most equal to a length which corresponds approximately to the length (1) of the inner cathode ring (2) plus twice the thickness of the semiconductor body and minus the width (b) of the region (5) of the opposite conduction type.

2. GTO thyristor according to Claim 1,
characterized in that the region (5) is wider than 0.1 mm.

3. GTO thyristor according to Claim 1 or 2,
characterized in that the distance (a) between the anode emitter zones (4) amounts to 0.1 to 0.6 mm.

4. GTO thyristor according to one of Claims 1 to 3, characterized in that the width of the anode emitter zones amounts to 0.1 to 0.6 mm.

## Revendications

1. Thyristor blocable comportant un élément à semiconducteur circulaire, qui a, côté cathode, une pluralité de zones d'émetteur en forme de bandes qui sont disposées en forme d'anneaux concentriques les uns par rapport aux autres de telle manière, que leurs axes longitudinaux sont dirigés radialement par rapport à l'élément à semiconducteur, et comportant des zones d'émetteur anodiques d'un premier type de conductivité annulaire, concentriques les unes par rapport aux autres et à distance les unes des autres, caractérisé en ce qu'il se trouve, entre un premier groupe de zones (4) d'émetteur anodiques qui font face à l'anneau (3) d'émetteur cathodique le plus à l'extérieur et un deuxième groupe de zones (4) d'émetteur anodiques qui font face à l'anneau (2) d'émetteur cathodique intérieur le plus proche, une région (5) du type de conductivité opposé qui est plus large que la distance (a) entre les zones d'émetteur anodiques à l'intérieur du premier ou du deuxième groupe, et en ce que la distance (c) entre le bord intérieur de la zone d'émetteur anodique la plus à l'intérieur du deuxième groupe et le bord extérieur de la zone d'émetteur anodique la plus à l'extérieur du deuxième groupe est au plus égal à une longueur qui correspond à-peu-près à la longueur (I) de l'anneau (2) cathodique intérieur plus le double de l'épaisseur de l'élément à semiconducteur et moins la largeur (b) de la région (5) du type de conductivité opposé.

2. Thyristor blocable suivant la revendication 1,
caractérisé en ce que la largeur de la région (5) est supérieure à 0,1 mm.

3. Thyristor blocable suivant la revendication 1 ou 2,
caractérisé en ce que la distance (a) entre les zones (4) d'émetteur anodiques est de 0,1 à 0,6 mm.

4. Thyristor blocable suivant l'une des revendications 1 à 3,
caractérisé en ce que la largeur des zones d'émetteur anodiques est de 0,1 à 0,6 mm.
